# FASCICULE DE BREVET EUROPEEN

(11) **EP 2 075 223 B1**
(45) Date de publication et mention de la délivrance du brevet: **17.12.2014**
(21) Numéro de dépôt: 08172569.9
(22) Date de dépôt: 22.12.2008
(51) Int. Cl.: B81C 1/00

(54) **Dispositif a structure pré-libérée**
Device with pre-released structure
Vorrichtung mit vor-freigesetzter Struktur

(30) Priorité: 27.12.2007 FR 0760400
(43) Date de publication de la demande: 01.07.2009
(73) Titulaire: Commissariat à l'Énergie Atomique et aux Énergies Alternatives, 75015 Paris (FR)
(72) Inventeur: Caplet, Stéphane, 38360, SASSENAGE (FR)
(74) Mandataire: Ilgart, Jean-Christophe

(56) Documents cités:
- EP-A1- 0 754 953
- WO-A-92/01941
- US-A1- 2007 069 342

## Description

### DOMAINE TECHNIQUE

L'invention concerne un dispositif comportant une structure pré-libérée réalisée dans une couche utile ainsi qu'un procédé de réalisation d'un tel dispositif. Ce dispositif peut notamment être un microsystème électromécanique (MEMS) et/ou un nanosystème électromécanique (NEMS), par exemple un capteur, la structure pré-libérée comportant par exemple un ou plusieurs éléments mobiles du MEMS ou du NEMS. Ce dispositif peut également comporter des éléments de type CMOS destinés à fonctionner après la libération de structure.

### ÉTAT DE LA TECHNIQUE ANTÉRIEURE

Il est connu de réaliser un MEMS à partir d'un substrat SOI (silicium sur isolant) formé par une couche d'oxyde disposée entre un substrat et une couche utile à base de silicium. On réalise tout d'abord la structure du MEMS dans la couche utile par des étapes de lithographie et de gravure. Des trous de libération sont ensuite réalisés à travers la couche utile, permettant d'accéder à la couche d'oxyde. On supprime alors la portion de la couche d'oxyde reliant le MEMS au substrat pour libérer le MEMS, ou certains éléments du MEMS destinés à être mobiles, du substrat. Cette suppression de la portion de la couche d'oxyde est par exemple réalisée par une gravure humide mise en oeuvre par un agent de gravure introduit dans les trous de libération précédemment réalisés.

Dans un tel procédé, un nombre important de trous de libération doivent notamment être réalisés dans la couche utile pour que l'agent de gravure puisse supprimer entièrement la portion de la couche d'oxyde reliant le MEMS, ou les éléments mobiles du MEMS, au substrat, ce qui fragilise le MEMS. De plus, le temps nécessaire pour réaliser cette gravure est important.

Le document EP 0 754 953 A1 décrit un procédé de libération d'une structure micromécanique réalisée dans une couche utile d'un substrat SOI. Dans ce procédé, on réalise tout d'abord une première gravure partielle et sélective de la couche d'oxyde en laissant subsister plusieurs portions de la couche d'oxyde qui forment alors des espaceurs entre le substrat et la portion de la couche utile formant la structure. Une gravure de la couche utile et du substrat est ensuite mise en oeuvre en utilisant les espaceurs comme masque de gravure, formant ainsi des butées dans la couche utile et dans le substrat, au niveau des emplacements des espaceurs, utilisées en tant que butées anti-collage. On élimine enfin les espaceurs, libérant ainsi complètement la structure micromécanique du substrat.

Ces butées anti-collage sont utiles lorsque des éléments mobiles sont susceptibles de venir en contact avec d'autres éléments de la structure, pouvant entraîner un « collage » de ces éléments. En cas de collage, le mouvement des éléments mobiles n'est plus assuré durant le fonctionnement de la structure, la rendant alors défaillante. Les butées permettent de limiter la surface de contact en cas de collision et donc de réduire les risques de collage des éléments mobiles de la structure.

Toutefois, un nombre important de trous de libération doit également être réalisé dans la couche utile pour réaliser la première gravure partielle. De plus, la durée de mise en oeuvre de cette gravure est également très importante.

### EXPOSÉ DE L'INVENTION

Un but de la présente invention est de proposer un dispositif à structure pré-libérée permettant une libération ultérieure de la structure pouvant être plus rapide que les libérations de structure décrites dans l'art antérieur, et dont la structure ne soit pas fragilisée par la réalisation d'un nombre important de trous de libération dans cette structure.

Pour cela, la présente invention propose un dispositif à structure pré-libérée comportant :
- au moins un premier empilement, comprenant au moins une première couche à base d'au moins un premier matériau, disposé sur, ou contre, un second empilement comprenant au moins une seconde couche à base d'au moins un second matériau,
- au moins une cavité, par exemple fermée, réalisée dans le premier et/ou le second empilement, et disposée entre une portion du premier empilement formant la structure pré-libérée et le second empilement,
- au moins un espaceur disposé dans la cavité et s'étendant entre la portion du premier empilement et le second empilement, c'est-à-dire reliant ou joignant la portion du premier empilement au second empilement.

Le terme « empilement », ici et dans tout le reste du document, doit être compris comme étant « au moins une couche ».

Avec un tel dispositif, la libération de la structure peut être réalisée très rapidement car seul un ou les espaceurs disposés entre la structure et le second empilement sont destinés à être libérés du premier ou second empilement, ce qui représente une surface à graver plus réduite par rapport aux dispositifs de l'art antérieur dans lesquels une surface équivalente à celle de la structure en contact avec un substrat doit être gravée. De plus, étant donné qu'une cavité fermée est formée dans l'un ou les deux empilements, pouvant s'étendre sous toute la structure pré-libérée formée par une portion du premier empilement, des trous de libération supplémentaires dans la structure ne sont plus nécessaires, un seul accès à la cavité étant suffisant pour libérer entièrement la structure. Ce dispositif offre donc une plus grande liberté de conception en ce qui concerne le design de la structure.

De plus, la structure pré-libérée selon l'invention permet de mettre en oeuvre des étapes de formation, ou réalisation, des MEMS, NEMS et/ou dispositifs MOS ou CMOS avant leur libération dans ou sur, ou contre, la structure pré-libérée, permettant ainsi d'éviter une déformation de la structure même lors d'étapes induisant des températures importantes. De plus, grâce à l'invention, un ou plusieurs dispositifs de type MEMS et/ou NEMS et/ou MOS et/ou CMOS, ou encore d'autres types, peuvent être réalisés dans ou sur, ou contre, la structure pré-libérée sans contrainte de design de par l'absence d'ouvertures ou d'accès à la cavité dans la structure.

Les ancrages des espaceurs étant éliminés lors de la libération de la structure, le dispositif selon l'invention peut comporter une grande densité d'espaceurs dans la cavité notamment pour optimiser le maintien, ou l'ancrage, mécanique de la structure pré-libérée, en particulier lorsque celle-ci supporte des étapes de procédé induisant des contraintes mécaniques. La densité des espaceurs est donc telle que l'on obtienne un maintien mécanique de la structure pré-libérée suffisant.

La présente invention propose également un dispositif à structure pré-libérée comportant au moins une première couche à base d'au moins un premier matériau disposée sur, ou contre, une seconde couche à base d'au moins un second matériau, au moins une cavité, par exemple fermée, réalisée au moins dans la première couche et/ou la seconde couche et disposée entre une portion de la première couche, ladite portion pouvant être destinée à former la structure, et la seconde couche, et au moins un espaceur, ou micro-pilier, disposé dans la cavité et s'étendant entre la portion de la première couche et la seconde couche, c'est-à-dire reliant ou joignant la portion de la première couche à la seconde couche.

La structure réalisée dans le premier empilement, pouvant comprendre la couche utile, peut comporter par exemple un élément sensible d'un capteur, tel qu'une masse sismique d'un accéléromètre ou une membrane d'un capteur de pression, ou encore un élément mobile d'un MEMS tel qu'un peigne.

Le premier et/ou le second empilement peut comporter en outre au moins une couche intermédiaire disposée entre la première couche et la seconde couche, la cavité pouvant être réalisée dans la couche intermédiaire et/ou la première couche et/ou la seconde couche.

Dans ce cas, la couche intermédiaire peut être à base d'un matériau diélectrique tel qu'un oxyde du premier et/ou du second matériau, et/ou un oxyde de semi-conducteur. Le dispositif peut ainsi former une structure pré-libérée dans un substrat SOI.

Le dispositif peut comporter plusieurs groupes d'espaceurs, les espaceurs de chaque groupe pouvant comporter, dans un plan parallèle à un plan passant par une face principale de la première couche ou de la seconde couche ou d'une couche intermédiaire (lorsque le dispositif comporte une telle couche intermédiaire), une section différente des espaceurs des autres groupes.

Le dispositif peut comporter une pluralité d'espaceurs répartis dans la cavité tel que la distance entre deux espaceurs voisins soit inférieure à environ cinquante fois l'épaisseur de la portion du premier empilement.

La section des espaceurs, dans un plan parallèle à un plan passant par une face principale de la première couche ou de la seconde couche, peut être choisie en fonction des contraintes mécaniques que peut subir la structure avant sa libération. Cette section peut notamment être comprise entre environ 7 µm² et 16 µm².

Le premier matériau peut être un matériau semi-conducteur. Le second matériau peut être un matériau semi-conducteur, ou matériau diélectrique tel que du verre et/ou de la silice. Ainsi, la structure peut être réalisée dans la couche utile d'un substrat de type silicium sur verre, ou silicium sur borosilicate.

La présente invention concerne également un procédé de réalisation d'un dispositif à structure pré-libérée, comportant au moins les étapes de :
- réalisation d'au moins un creux dans un premier empilement, comprenant au moins une première couche à base d'au moins un premier matériau, et/ou dans un second empilement, comprenant au moins une seconde couche à base d'au moins un second matériau en laissant subsister au moins une saillie dans le creux,
- collage du premier empilement sur, ou contre, le second empilement, le creux formant une cavité, par exemple fermée, disposée entre une portion du premier empilement formant la structure pré-libérée et le second empilement, la saillie formant un espaceur s'étendant entre la portion du premier empilement et le second empilement, c'est-à-dire reliant ou joignant la portion du premier empilement au second empilement.

Le premier et/ou le second empilement peuvent comporter en outre au moins une couche intermédiaire, le creux pouvant être alors réalisé dans la couche intermédiaire et/ou dans la première couche et/ou dans la seconde couche, et la couche intermédiaire pouvant être alors disposée, après l'étape de collage, entre la première couche et la seconde couche.

L'étape de réalisation du creux peut laisser subsister plusieurs groupes de saillies, les saillies de chaque groupe pouvant comporter, dans un plan parallèle à un plan passant par une face principale de la première couche ou de la seconde couche ou d'une couche intermédiaire (lorsque le dispositif comporte une telle couche intermédiaire), une section différente des saillies des autres groupes, les saillies pouvant former, après l'étape de collage, des espaceurs pouvant s'étendre entre la portion du premier empilement et le second empilement.

Le procédé peut comporter en outre une étape d'amincissement du premier et/ou du second empilement.

Le procédé peut comporter en outre une étape de réalisation d'au moins une zone de fragilisation dans le premier et/ou le second empilement, l'étape d'amincissement pouvant être réalisée par la mise en oeuvre d'au moins une étape de fracture au niveau de la zone de fragilisation.

Le creux et la saillie peuvent être obtenus par la mise en oeuvre d'au moins une étape de lithographie et d'au moins une étape de gravure dans le premier et/ou le second empilement.

L'étape de collage peut être un collage moléculaire ou un scellement anodique réalisé entre le premier et le second empilement.

La présente invention concerne aussi un procédé de réalisation d'une structure dans un dispositif, comportant au moins les étapes de :
- mise en oeuvre d'un procédé de réalisation d'un dispositif à structure pré-libérée tel que décrit précédemment,
- réalisation d'au moins un accès à la cavité,
- gravure d'au moins une portion du premier ou du second empilement reliant mécaniquement l'espaceur au premier ou au second empilement et/ou de tout ou partie de l'espaceur, libérant la portion du premier empilement, du second empilement.

L'invention concerne aussi un procédé de libération d'une structure d'un dispositif tel que décrit précédemment, comportant au moins les étapes de :
- réalisation d'au moins un accès à la cavité,
- gravure d'au moins une portion du premier ou second empilement reliant mécaniquement l'espaceur au premier ou au second empilement et/ou de tout ou partie de l'espaceur, libérant la portion du premier empilement, du second empilement.

Le ou les espaceurs, ou micro-piliers, réalisent donc, avant la libération de la structure, à la fois les fonctions de soutien mécanique et de pont thermique pendant des étapes réalisées sur la structure avant la libération, et peuvent former, après la libération de la structure, des pions, ou butées, pouvant permettre d'assurer une fonction anti-collage, c'est-à-dire des saillies réduisant les risques de collage de la structure libérée avec notamment la seconde couche lorsque la structure est mobile et que celle-ci vient au contact de la seconde couche.

La réalisation de l'accès à la cavité peut être obtenue par au moins une étape de lithographie et au moins une étape de gravure.

L'étape de gravure peut réaliser également la gravure de tout ou partie des espaceurs.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 3 représentent les étapes d'un procédé de réalisation d'une structure pré-libérée, objet de la présente invention, selon un premier mode de réalisation,
- les figures 4 et 5 représentent des étapes d'un procédé de réalisation d'une structure dans un dispositif, objet de la présente invention, ou d'un procédé de libération d'une structure d'un dispositif, également objet de la présente invention, selon un premier mode de réalisation, à partir d'une structure pré-libérée, également objet de la présente invention,
- les figures 6 à 10 représentent les étapes d'un procédé de réalisation d'une structure pré-libérée, objet de la présente invention, selon un second mode de réalisation, et les étapes d'un procédé de libération d'une structure d'un dispositif, également objet de la présente invention, selon un second mode de réalisation, à partir d'une structure pré-libérée,
- la figure 11 représente une vue en coupe de dessus d'un dispositif à structure pré-libérée, objet de la présente invention, dans une variante du second mode de réalisation,
- la figure 12 représente un dispositif à structure pré-libérée, objet de la présente invention, dans une variante du premier mode de réalisation,
- les figures 13A et 13B représentent un dispositif à structure pré-libérée, respectivement avant et après la libération de la structure, objet de la présente invention, dans une variante du premier mode de réalisation,
- les figures 14A à 14F représentent les étapes d'un procédé de réalisation d'un capteur de pression à partir d'un substrat SOI à structure pré-libérée, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

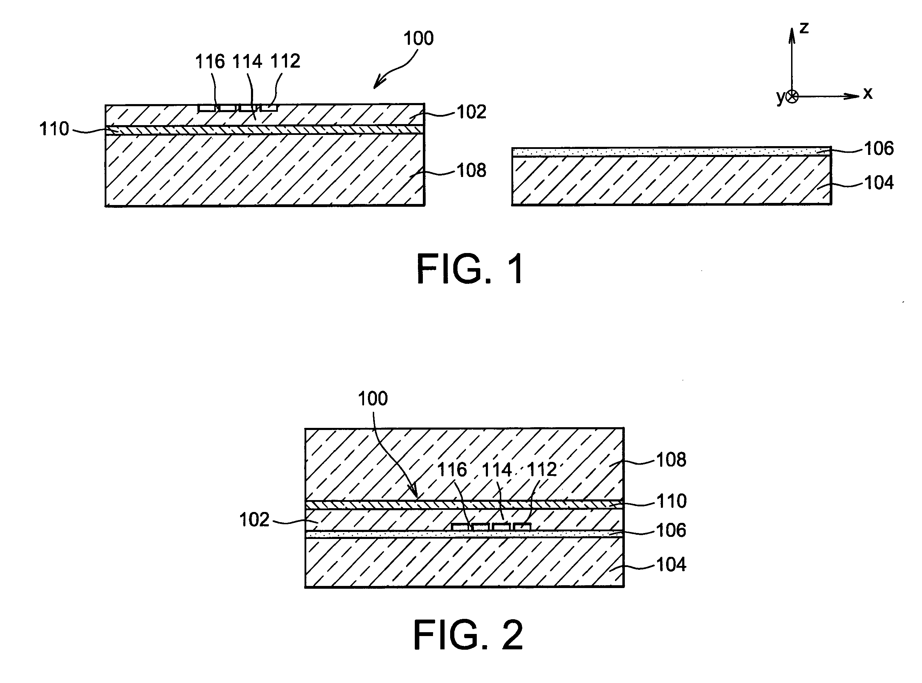

On se réfère tout d'abord aux figures 1 à 3 qui représentent les étapes d'un procédé de réalisation d'un dispositif 100 à structure pré-libérée réalisée dans une couche utile 102 liée à un substrat 104, selon un premier mode de réalisation.

Comme représenté sur la figure 1, on réalise tout d'abord, sur un premier substrat 104, une couche diélectrique 106. Dans ce mode de réalisation décrit, le premier substrat 104 est à base d'au moins un semi-conducteur, par exemple du silicium, la couche diélectrique 106 étant à base d'un oxyde, par exemple de l'oxyde de silicium obtenu par oxydation du silicium du substrat 104.

On réalise également un premier empilement formé par un second substrat 108, également à base d'au moins un semi-conducteur tel que du silicium, sur lequel est réalisée une couche 110 à base d'au moins un matériau différent de celui du second substrat 108. Dans le mode de réalisation décrit ici, cette couche 110 est une couche sacrificielle, par exemple à base d'un oxyde de semi-conducteur ou de semi-conducteur tel que du silicium-germanium, permettant un amincissement ultérieur du premier empilement formé par le second substrat 108, la couche sacrificielle 110 et la couche utile 102. La couche utile 102, ici à base d'au moins un semi-conducteur tel que du silicium, est ensuite réalisée sur la couche sacrificielle 110. De manière générale, la couche utile 102 a par exemple une épaisseur comprise entre environ 5 µm et 4 mm, et de préférence comprise entre environ 5 µm et 200 µm. De plus, les matériaux des couches 102 et 106 sont choisis tels que celui de la couche 106 puisse être gravé sélectivement par rapport à celui de la couche utile 102. Le premier substrat 104 et la couche diélectrique 106 forment un second empilement.

On réalise ensuite des étapes de lithographie et de gravure dans la couche utile 102, formant un creux 112. Ce creux 112 est réalisé au-dessus d'une portion 114 de la couche utile 102 à partir de laquelle la structure pré-libérée va être réalisée. Les dimensions de ce creux 112 sont adaptées en fonction de la taille et de la forme de la structure souhaitée. Le creux 112 a par exemple des dimensions égales à quelques centaines de micromètres, c'est-à-dire inférieures à environ 1 mm. Le motif lithographié et gravé dans la couche utile 102 forme également des saillies 116 dans le creux 112, au-dessus de la portion 114 de la couche utile 102. Sur la figure 1, trois saillies 116 sont représentées. Dans cet exemple de réalisation, le creux 112 est réalisé dans le premier empilement.

Les saillies 116 sont ici réparties de façon relativement homogène dans le creux 112, avec un pas, c'est-à-dire un espacement entre deux saillies 116 voisines égale à quelques micromètres, par exemple compris entre environ 5 µm et 15 µm. Les saillies 116 ont par exemple, dans un plan parallèle au plan (x,y), qui est par exemple le plan principal de la couche utile 102, une section dont la surface est comprise entre environ 7 µm² et 16 µm². Cette section est par exemple de forme rectangulaire, les dimensions des côtés étant comprises entre environ 3 µm et 4 µm, ou a une forme de disque dont le rayon est compris entre environ 3 µm et 4 µm. Cette section peut également être d'une toute autre forme, régulière ou non. La profondeur du creux 112 est adaptée en fonction de l'épaisseur de la couche utile 102.

La profondeur du creux 112 est notamment choisie pour ne pas affaiblir mécaniquement la couche 102. De plus, cette profondeur du creux 112 est choisie pour obtenir une uniformité de gravure de libération au niveau des zones se trouvant entre deux ouvertures (trous ou tranchées) d'accès pour l'agent de gravure utilisé lors de la libération ultérieure de la structure, et pour que l'agent de gravure puisse être acheminé partout dans le creux et éliminer les éléments destinés à être gravés. Dans le cas d'un empilement formant un substrat SOI avec un creux réalisé dans la couche superficielle, cette profondeur est par exemple égale à l'épaisseur de la couche d'oxyde.

Comme représenté sur la figure 2, on réalise ensuite un collage, par exemple un collage moléculaire, entre la couche diélectrique 106 et la couche utile 102. Le creux 112 forme donc une cavité fermée disposée entre la couche diélectrique 106 et la portion 114 de la couche utile 102. Les saillies 116 forment également des espaceurs, ou micro-piliers, s'étendant entre la portion 114 de la couche utile 102 et la couche diélectrique 106, dans la cavité 112, c'est-à-dire reliant ou joignant la portion 114 de la couche utile 108 à la couche diélectrique 106.

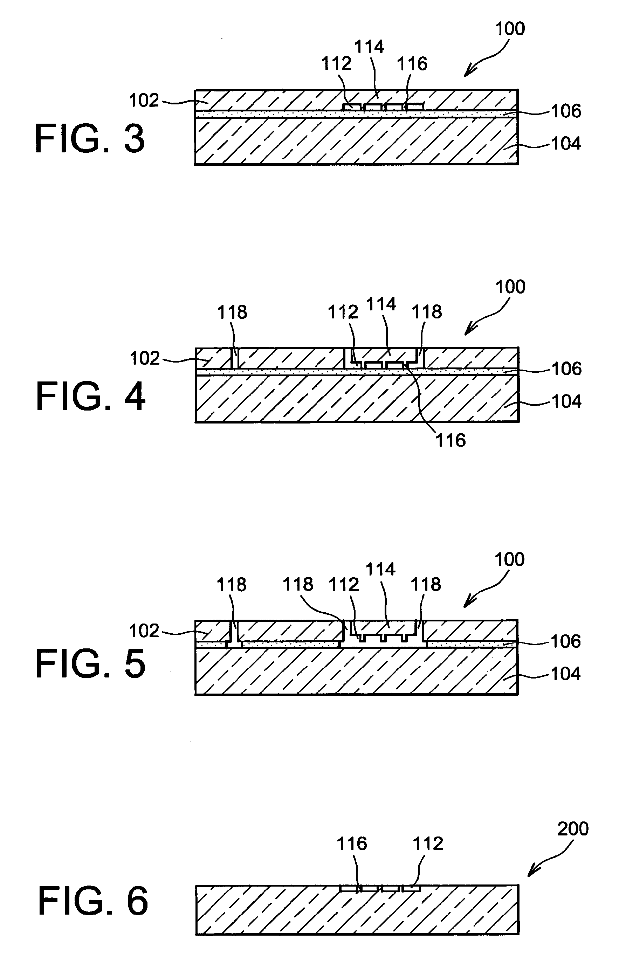

Comme représenté sur la figure 3, on supprime ensuite, par exemple par gravure sacrificielle de l'oxyde ou HF, le second substrat 108 et la couche de SiGe 110. On obtient alors un dispositif 100 comportant une structure pré-libérée formée par la portion de semi-conducteur 114 de la couche utile 102 liée au substrat 104 par l'intermédiaire d'une portion de la couche diélectrique 106 et des espaceurs 116. Les espaceurs 116 servent donc ici de soutien mécanique à la portion 114, ainsi que de pont thermique.

On se réfère maintenant aux figures 4 et 5 qui représentent des étapes de réalisation de la structure dans le dispositif 100, à partir du dispositif 100 à structure pré-libérée décrit précédemment et représenté sur la figure 3.

Sur la figure 4, la portion 114 de la couche utile 102, c'est-à-dire la structure pré-libérée du dispositif 100, est mise en forme par des étapes de lithographie et de gravure. Dans l'exemple de réalisation décrit, le dispositif 100 est un MEMS, par exemple un accéléromètre, la structure formée par la portion 114 de la couche utile 102 étant destinée à être une membrane suspendue. Sur la figure 4, des tranchées d'isolation 118 réalisées à travers la couche utile 102 mettent en forme et délimitent la structure du reste de la couche utile 102. Ces tranchées 118 forment également un accès à la cavité 112 et à la couche diélectrique 106, et notamment aux portions de la couche diélectrique 106 reliées aux espaceurs 116.

Comme représenté sur la figure 5, la structure formée par la portion 114 est alors libérée du substrat 104 en gravant, par exemple, par une gravure humide à l'acide fluorhydrique, les portions de la couche diélectrique 106 reliant les espaceurs 116 au substrat 104, agrandissant la cavité 112 précédemment réalisée. La structure formée par la portion 114 de la couche utile 102 est donc libérée du substrat 104, ainsi que de la couche diélectrique 106.

Par rapport aux procédés de l'art antérieur, la libération de la structure selon le procédé décrit ne nécessite pas de réaliser des trous de libération supplémentaires dans la portion 114 de la couche utile 102 pour pouvoir y introduire un agent de gravure de la couche diélectrique 106. En effet, étant donné que la cavité 112 permet d'accéder à toutes les portions de la couche diélectrique 106 reliées aux espaceurs 116, l'agent de gravure peut atteindre la totalité de ces portions de la couche diélectrique 106 reliant la portion 114 de la couche utile 102 au substrat 104 uniquement à partir des tranchées 118 délimitant la structure. De plus, étant donné que les espaceurs 116 sont réalisés dans la couche utile 102 avant que cette couche soit assemblée au substrat 104 et à la couche diélectrique 106, les espaceurs 116 peuvent être réalisés sans réaliser de nombreux trous dans la portion 114 de la couche utile 102 qui fragiliseraient la portion 114. Quelques trous de libération supplémentaire peuvent toutefois être formés à travers la couche utile si l'on souhaite améliorer la répartition fluidique de l'agent de gravure lors de la gravure sacrificielle.

Ce procédé permet également de réduire le temps de libération de la structure. Par exemple, dans les procédés de l'art antérieur décrits précédemment, il est nécessaire de réaliser des trous de libération espacés d'environ 30 µm dans la portion de semi-conducteur destinée à former la structure. Le temps pour la libération de la structure est dans ce cas le temps mis par l'agent de gravure pour graver une portion d'oxyde (dans le cas d'un substrat SOI) formant un cylindre de diamètre légèrement inférieur à la moitié de la distance entre deux trous, par exemple environ 15 µm. Cette durée peut être réduite en rapprochant les trous de libération entre eux, mais cela implique un nombre de trous de libération dans la structure à libérer encore plus important, ce qui peut fragiliser encore plus la structure. Dans le dispositif décrit ici, le temps de libération de la structure correspond au temps mis pour graver les portions de la couche diélectrique 106 se trouvant sous les espaceurs 116, c'est-à-dire des portions dont les dimensions dans un plan parallèle au plan principal (x,y) de la couche utile 102 sont comprises entre environ 3 µm et 4 µm, soit un temps de gravure environ cinq fois moins important que celui nécessaire dans les procédés de l'art antérieur.

De plus, après la libération de la structure, les espaceurs 116 forment des butées permettant de réduire le risque de collage entre la structure et le substrat 104, grâce à une surface de contact réduite en cas de contact.

Dans une variante du mode de réalisation décrit, il est possible de remplacer le substrat 104 et la couche diélectrique 106 par une unique couche formant un substrat. Dans ce cas, ce substrat peut être à base de verre, par exemple de type borosilicate. Le collage entre la couche utile 102 et ce substrat peut alors être réalisé par un collage moléculaire ou un scellement anodique. Dans cette variante de réalisation, la libération de la structure est alors obtenue en gravant les ancrages, c'est-à-dire des portions du substrat reliées directement aux espaceurs. Cette gravure peut être une gravure isotrope à l'acide fluorhydrique.

Tous les avantages décrits précédemment en liaison avec le dispositif 100 s'appliquent également avec cette variante : libération de la structure sans les nombreux trous de libération dans la couche utile, réduction du temps de libération de la structure, présence des espaceurs formant des butées anti-collage. Il est également possible de ne réaliser la cavité dans la couche utile que sous une partie seulement de la portion de la couche utile destinée à former la structure. Par exemple, dans le cas d'un MEMS à peignes interdigités, il est possible de ne réaliser la cavité que sous la portion de la couche utile destinée à former un peigne mobile, la cavité n'étant pas réalisée sous la portion de la couche utile destinée à former les peignes fixes.

On se réfère maintenant aux figures 6 à 10 qui représentent les étapes d'une réalisation d'un dispositif 200 à structure pré-libérée et de la libération de cette structure selon un second mode de réalisation.

Comme représenté sur la figure 6, par rapport au premier mode de réalisation, le creux 112 et les saillies 116 sont réalisés dans un substrat massif 202, ici à base de silicium, par exemple par des étapes de lithographie et de gravure ionique réactive (RIE). La profondeur du creux 112 est ici égale à quelques centaines de nanomètres, c'est-à-dire inférieure à environ 1 micromètre. Le substrat 202 est appelé premier empilement.

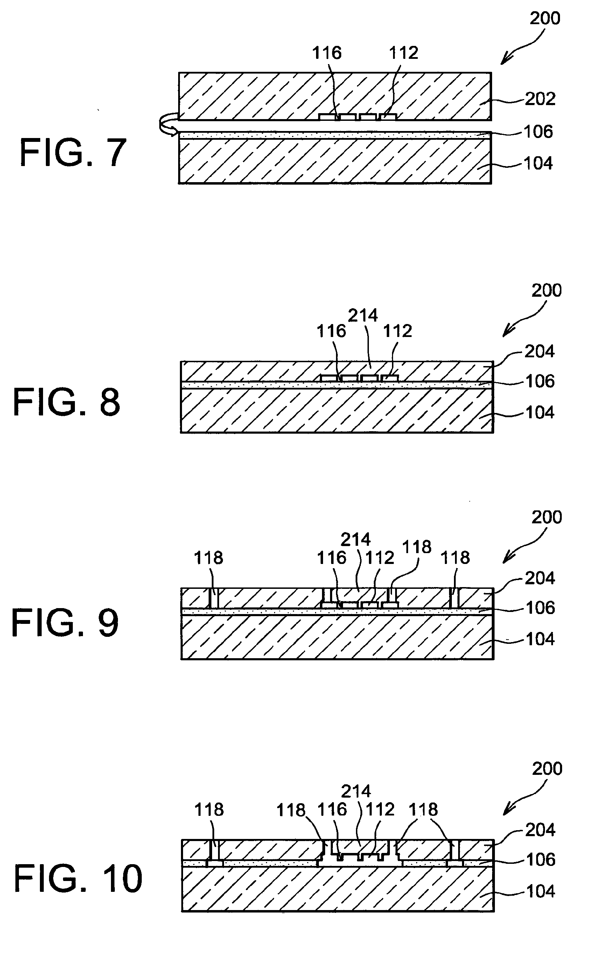

Le substrat 202 est ensuite solidarisé par un scellement au second empilement formé par le substrat 104 à base de silicium et la couche diélectrique 106 à base d'oxyde de silicium (figure 7).

Sur la figure 8, le substrat 202 est aminci à l'épaisseur souhaitée, formant ainsi une couche 204 de silicium. Le substrat 104, la couche d'oxyde 106 et la couche 204 forment donc une structure SOI, la couche 204 formant la couche superficielle de silicium de cette structure. Une portion 214 de la couche 204 se trouvant au-dessus de la cavité 112 forme la structure pré-libérée du dispositif 200.

La portion 214 de la couche utile 204 est mise en forme par des étapes de lithographie et de gravure, par exemple RIE (figure 9). Comme dans le premier mode de réalisation décrit précédemment, des tranchées d'isolation 118 réalisées à travers la couche utile 204 mettent en forme et délimitent la structure du reste de la couche utile 204. Ces tranchées 118 forment également un accès à la cavité 112 et à la couche diélectrique 106, et notamment aux portions de la couche diélectrique 106 reliées aux espaceurs 116.

Enfin, comme représenté sur la figure 10, la structure formée par la portion 114 est alors libérée du substrat 104 en gravant les portions de la couche diélectrique 106 reliées aux espaceurs 116.

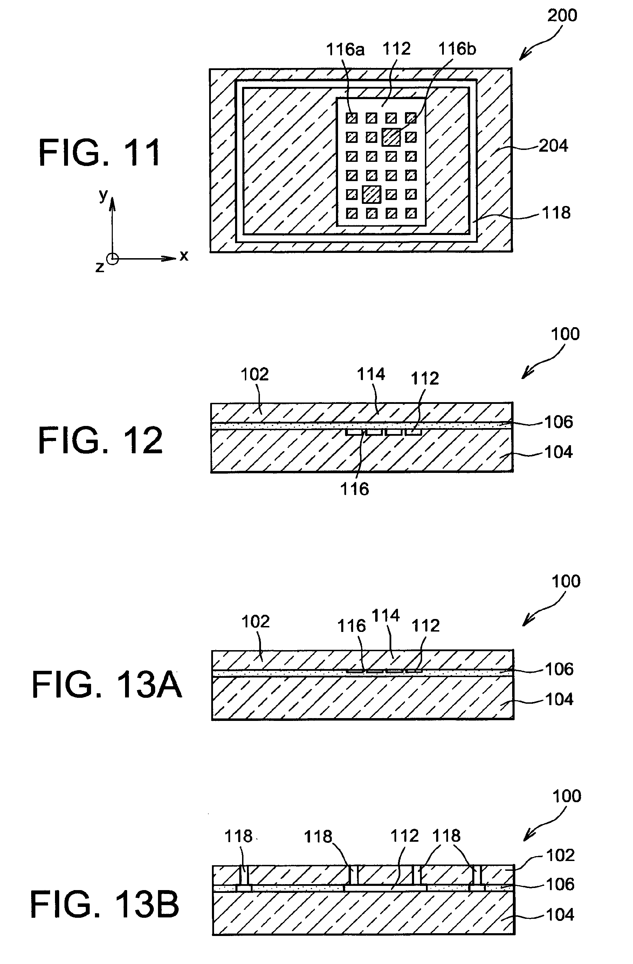

Dans une variante des modes de réalisation décrits précédemment, il est possible de réaliser, dans la cavité du dispositif à structure pré-libérée, des espaceurs dont la densité de répartition dans la cavité soit sensiblement uniforme et comportant des dimensions de section, dans un plan parallèle au plan principal du dispositif, différentes. La figure 11 représente une vue en coupe du dispositif 200 (dans un plan principale de la couche 204) selon cette variante de réalisation. Comme on peut le voir sur cette figure 11, un premier groupe d'espaceurs 116a comporte une section de dimensions inférieures à celles de la section d'un second groupe d'espaceurs 116b.

Dans cette variante de réalisation, la libération de la portion 114 formant la structure est réalisée en deux étapes : on grave tout d'abord les portions de la couche diélectrique 106 reliant le premier groupe d'espaceurs 116a au substrat 104 puis, on libère par une seconde gravure les portions de la couche diélectrique 106 reliant le second groupe d'espaceurs 116b au substrat 104. Entre ces deux étapes de gravure, il est possible de réaliser des butées anti-collage dans la couche 204, au niveau des espaceurs 116b encore présents dans la cavité 112, en mettant en oeuvre par exemple le procédé décrit dans le document EP 0 754 953 A1.

Les dimensions des côtés de la cavité 112 dans le plan (x,y) peuvent par exemple être égales à quelques centaines de micromètres, ou inférieures à environ 1 mm. Lorsque la portion de la couche 204 se trouvant au-dessus de la cavité 112 est destinée à former un MEMS, les espaceurs 116a ont par exemple une section, dans le plan (x,y), dont les dimensions des côtés sont comprises entre environ 3 µm et 5 µm, deux espaceurs 116a voisins étant par exemple distant d'une longueur comprise entre environ 8 µm et 15 µm. Lorsque la portion de la couche 204 se trouvant au-dessus de la cavité 112 est destinée à former un NEMS, les espaceurs 116a peuvent dans ce cas avoir section dans le plan (x,y) dont les côtés ont des dimensions comprises entre environ 0,2 µm et 0,5 µm, espacés d'un pas (distance entre deux espaceurs voisins) compris entre environ 1 µm et 2 µm. Les sections des espaceurs 116b dans le plan (x,y) peuvent avoir des côtés dont les dimensions sont supérieures d'environ 3 µm à 5 µm par rapport aux dimensions des sections des espaceurs 116a. Les dimensions des espaceurs peuvent être plus réduites si des moyens de lithographie avancés sont utilisés. Par exemple, dans le cas d'espaceurs 116a dont les dimensions des sections dans le plan (x,y) sont égales à environ 1 µm, le pas d'espacement peut être compris entre environ 0,2 µm et 0,5 µm.

Dans les modes de réalisation décrits précédemment, la cavité 112 est formée dans le premier empilement, c'est-à-dire dans la ou les couches qui sont reportées sur le second empilement (dans la couche 102 pour le dispositif 100 et dans la couche 202, 204 pour le dispositif 200). Dans une variante des précédents modes de réalisation, il est possible de réaliser la cavité 112 et les espaceurs 116 dans le second empilement, c'est-à-dire dans le substrat 104. Dans ce cas, la cavité 112 est formée entre une portion du substrat 104 et la couche diélectrique 106. Dans ce cas, la libération peut être réalisée de manière similaire aux modes de réalisation décrits précédemment, c'est-à-dire en gravant le premier empilement (couche 102 ou couche 204) et la couche diélectrique 106 pour amener l'agent de gravure dans la cavité 112 et ainsi libérer la portion 114 de la couche 102 ou de la couche 204 destinée à former la structure libérée. La figure 12 représente le dispositif 100 dans cette variante de réalisation.

Dans une autre variante, la cavité 112 et les espaceurs 116 peuvent être réalisés dans la couche diélectrique 106. La figure 13A représente le dispositif 100 dans cette variante de réalisation. Lorsque la structure formée par la portion 114 de la couche 102 est ensuite libérée (voir figure 13B), l'ensemble de la portion de la couche diélectrique 106 se trouvant au niveau de la cavité 112 est gravée. Contrairement aux exemples décrits précédemment, les espaceurs 116 ne sont plus présents dans la cavité 112 après la libération de la structure pré-libérée.

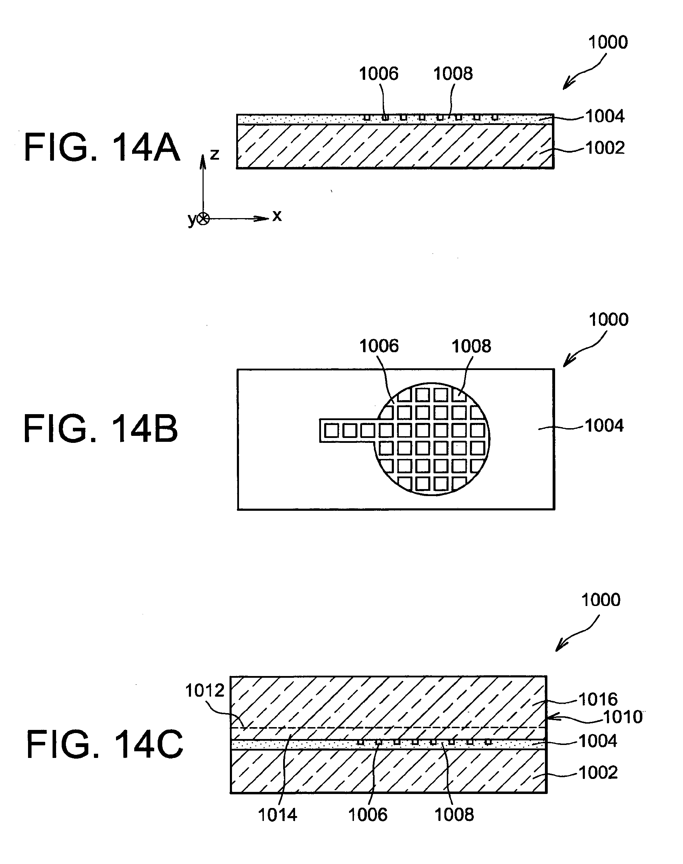

Un exemple de réalisation d'un capteur de pression 1000 à partir d'un substrat SOI à structure pré-libérée va maintenant être décrit en liaison avec les figures 14A à 14F.

Comme représenté sur la figure 14A, on réalise tout d'abord une oxydation thermique d'un substrat de silicium 1002, formant une couche d'oxyde de silicium 1004 d'épaisseur comprise entre environ 0,2 µm et 0,4 µm. Une cavité 1006 comprenant des saillies 1008 est ensuite réalisée dans la couche d'oxyde 1004, par exemple de manière similaire à la cavité 112 décrite précédemment. Les saillies 1008 ont ici une section, dans un plan parallèle au plan (x,y), dont les côtés ont des dimensions comprises entre environ 0,5 µm et 1 µm. Le pas d'espacement entre les saillies 1008 est par exemple compris entre environ 0,1 µm et 0,2 µm. La cavité 1006 est réalisée dans la couche d'oxyde 1004 sur une profondeur comprise entre environ 0,1 µm et 0,2 µm.

Comme cela est représenté sur la figure 14B qui représente une vue de dessus du capteur 1000, le motif de la cavité 1006 comporte un disque destiné à délimiter la future membrane du capteur 1000. Ce motif comporte également un ou plusieurs canaux destinés à déporter la réalisation de la ou des ouvertures de libération. On conservera ainsi la membrane du capteur 1000 intacte.

On réalise ensuite un collage moléculaire d'un substrat de silicium 1010, par exemple monocristallin, comportant une zone fragilisée 1012 créée préalablement au collage moléculaire (figure 14C). La zone fragilisée 1012 sépare le substrat 1010 en deux couches 1014 et 1016. La cavité 1006 devient ainsi une cavité fermée, les saillies 1008 formant alors des espaceurs s'étendant entre le substrat 1010 et l'empilement formé par la couche d'oxyde 1004 et le substrat 1002. La densité des espaceurs 1008 est notamment choisie pour que l'onde de collage moléculaire se propage bien et que le collage soit réalisé au niveau des espaceurs 1008. Dans cet exemple de réalisation, la cavité 1006 est donc formée dans la couche d'oxyde 1004.

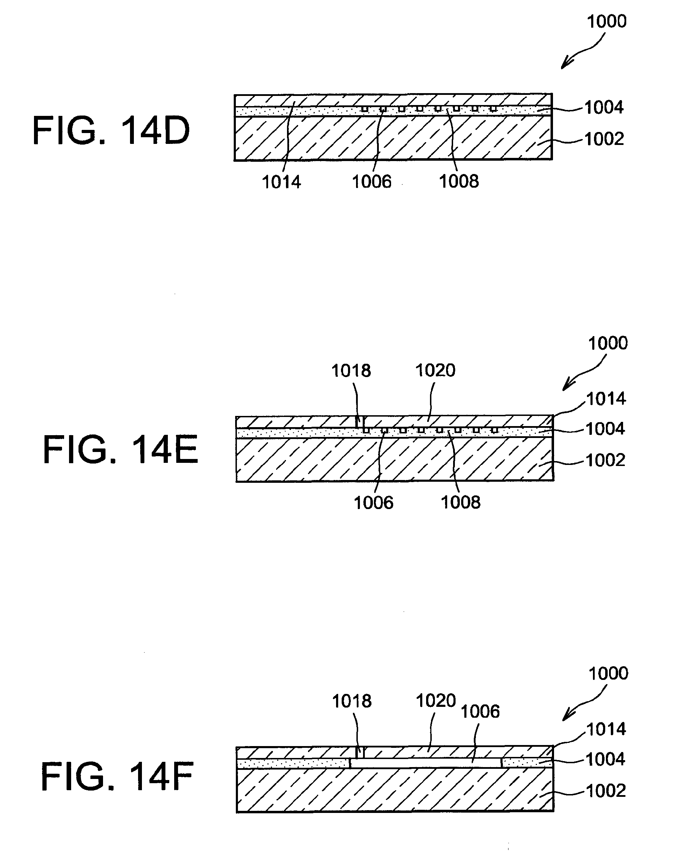

Sur la figure 14D, on réalise une fracture du substrat 1010 au niveau de la zone fragilisée 1012, supprimant ainsi la couche 1016 du dispositif 1000. Cette étape de fracturation peut être suivie d'une étape de polissage mécano-chimique de la surface de la couche 1014 issue du substrat 1010. La densité des espaceurs 1008 est également choisie pour assurer une bonne tenue mécanique de la couche 1014 lors de l'étape de fracture.

On réalise ensuite au moins une ouverture 1018 à travers la couche 1014 avant de former un accès à la cavité 1006 (figure 14E). Lorsque le motif de la cavité 1006 comporte un canal d'accès, la ou les ouvertures sont réalisées à travers la couche 1014 au niveau de ce canal d'accès, laissant ainsi intacte une portion 1020 de la couche 1014 destinée à former la membrane du capteur 1010.

Comme représenté sur la figure 14F, on réalise ensuite une gravure du matériau de la couche d'oxyde 1004 se trouvant au niveau de la cavité 1006, libérant ainsi la membrane formée par la portion 1020 de la couche de silicium 1014. La ou les ouvertures de libération 1018 peuvent ensuite être rebouchées par exemple par un dépôt sous vide, le matériau déposé étant ensuite gravé sélectivement par une étape de lithographie et de gravure, permettant de ne conserver que le matériau précédemment déposé au niveau des ouvertures 1018.

## Revendications

1. Dispositif (100, 200, 1000) à structure pré-libérée comportant :
- au moins un premier empilement, comprenant au moins une première couche (102, 204, 1014) à base d'au moins un premier matériau, disposé contre un second empilement comprenant au moins une seconde couche (104, 1002) à base d'au moins un second matériau,
- au moins une cavité (112, 1006) fermée, réalisée dans le premier et/ou le second empilement, et disposée entre une portion (114, 214, 1020) du premier empilement formant la structure pré-libérée et le second empilement,
- au moins un espaceur (116, 116a, 116b, 1008) disposé dans la cavité (112, 1006) et reliant la portion (114, 214, 1020) du premier empilement au second empilement.

2. Dispositif (100, 200, 1000) selon la revendication 1, dans lequel le premier et/ou le second empilement comportent en outre au moins une couche intermédiaire (106, 1004) disposée entre la première couche (102, 204, 1014) et la seconde couche (104, 1002), la cavité (112) étant réalisée dans la couche intermédiaire (106, 1004) et/ou la première couche (102, 204, 1014) et/ou la seconde couche (104, 1002).

3. Dispositif (100, 200, 1000) selon la revendication 2, dans lequel la couche intermédiaire (106, 1004) est à base d'un matériau diélectrique tel qu'un oxyde du premier et/ou du second matériau, et/ou un oxyde de semi-conducteur.

4. Dispositif (200) selon l'une des revendications précédentes, comportant plusieurs groupes d'espaceurs (116a, 116b), les espaceurs (116a, 116b) de chaque groupe comportant, dans un plan parallèle à un plan passant par une face principale de la première couche (204) ou de la seconde couche (104) ou d'une couche intermédiaire (106), une section différente des espaceurs (116a, 116b) des autres groupes.

5. Dispositif (100, 200, 1000) selon l'une des revendications précédentes, comportant une pluralité d'espaceurs (116, 116a, 116b, 1008) répartis dans la cavité (112, 1006) tel que la distance entre deux espaceurs (116, 116a, 116b, 1008) voisins soit inférieure à environ cinquante fois l'épaisseur de la portion (114, 214, 1020) du premier empilement.

6. Dispositif (100, 200, 1000) selon l'une des revendications précédentes, dans lequel le premier matériau est un matériau semi-conducteur.

7. Dispositif (100, 200, 1000) selon l'une des revendications précédentes, dans lequel le second matériau est un matériau semi-conducteur, ou un matériau diélectrique tel que du verre et/ou de la silice.

8. Dispositif (1000) selon l'une des revendications précédentes, comportant dans le premier et/ou le second empilement, au moins une zone de fragilisation (1012) permettant la réalisation ultérieure d'un amincissement du premier et/ou du second empilement.

9. Procédé de réalisation d'un dispositif (100, 200, 1000) à structure pré-libérée, comportant au moins les étapes de :
- réalisation d'au moins un creux (112, 1006) dans un premier empilement, comprenant au moins une première couche (102, 204, 1014) à base d'au moins un premier matériau, et/ou dans un second empilement, comprenant au moins une seconde couche (104, 1002) à base d'au moins un second matériau en laissant subsister au moins une saillie (116, 116a, 116b, 1008) dans le creux (112, 1006),
- collage du premier empilement contre le second empilement, le creux (112, 1006) formant une cavité fermée disposée entre une portion (114, 214, 1020) du premier empilement formant la structure pré-libérée et le second empilement, la saillie (116, 116a, 116b, 1008) formant un espaceur reliant la portion (114, 214, 1020) du premier empilement au second empilement.

10. Procédé selon la revendication 9, dans lequel le premier et/ou le second empilement comportent en outre au moins une couche intermédiaire (106, 1004), le creux (112, 1006) étant alors réalisé dans la couche intermédiaire (106, 1004) et/ou dans la première couche (102, 204, 1014) et/ou dans la seconde couche (104, 1002), et la couche intermédiaire (106, 1004) étant alors disposée, après l'étape de collage, entre la première couche (102, 204, 1014) et la seconde couche (104, 1002).

11. Procédé selon l'une des revendications 9 ou 10, dans lequel l'étape de réalisation du creux (112) laisse subsister plusieurs groupes de saillies (116a, 116b), les saillies (116a, 116b) de chaque groupe comportant, dans un plan parallèle à un plan passant par une face principale de la première couche (204) ou de la seconde couche (104) ou d'une couche intermédiaire (106), une section différente des saillies (116a, 116b) des autres groupes, les saillies (116a, 116b) formant, après l'étape de collage, des espaceurs (116a, 116b) s'étendant entre la portion (214) du premier empilement et le second empilement.

12. Procédé selon l'une des revendications 9 à 11, comportant en outre une étape d'amincissement du premier et/ou du second empilement.

13. Procédé selon la revendication 12, comportant en outre une étape de réalisation d'au moins une zone de fragilisation (1012) dans le premier et/ou le second empilement, l'étape d'amincissement étant réalisée par la mise en oeuvre d'au moins une étape de fracture au niveau de la zone de fragilisation (1012).

14. Procédé selon l'une des revendications 9 à 13, dans lequel le creux (112, 1006) et la saillie (116, 116a, 116b, 1008) sont obtenus par la mise en oeuvre d'au moins une étape de lithographie et d'au moins une étape de gravure dans le premier et/ou le second empilement.

15. Procédé selon l'une des revendications 9 à 14, dans lequel l'étape de collage est un collage moléculaire ou un scellement anodique réalisé entre le premier et le second empilement.

16. Procédé de réalisation d'une structure dans un dispositif (100, 200, 1000), comportant au moins les étapes de :
- mise en oeuvre d'un procédé de réalisation d'un dispositif (100, 200, 1000) à structure pré-libérée selon l'une des revendications 9 à 15,
- réalisation d'au moins un accès (118, 1018) à la cavité (112, 1006),
- gravure d'au moins une portion du premier ou du second empilement reliant mécaniquement l'espaceur (116, 116a, 116b, 1008) au premier ou au second empilement et/ou de tout ou partie de l'espaceur (116, 116a, 116b, 1008), libérant la portion (114, 214, 1020) du premier empilement, du second empilement.

17. Procédé de libération d'une structure d'un dispositif (100, 200, 1000) selon l'une des revendications 1 à 8, comportant au moins les étapes de :
- réalisation d'au moins un accès (118, 1018) à la cavité (112, 1006),
- gravure d'au moins une portion du premier ou du second empilement reliant mécaniquement l'espaceur (116, 116a, 116b, 1008) au premier ou au second empilement et/ou de tout partie de l'espaceur (116, 116a, 116b, 1008), libérant la portion (114, 214, 1020) du premier empilement du second empilement.

18. Procédé selon l'une des revendications 16 ou 17, dans lequel la réalisation de l'accès (118) à la cavité (112) est obtenue par au moins une étape de lithographie et au moins une étape de gravure.

## Patentansprüche

1. Vorrichtung (100, 200, 1000) mit vor-freigesetzter Struktur, umfassend:
- wenigstens einen ersten Stapel, umfassend wenigstens eine erste Schicht (102, 204, 1014) auf Grundlage wenigstens eines ersten Materials, der gegen einen zweiten Stapel angeordnet ist, umfassend wenigstens eine zweite Schicht (104, 1002) auf Grundlage wenigstens eines zweiten Materials,
- wenigstens einen geschlossenen Hohlraum (112, 1006), der in dem ersten und/oder dem zweiten Stapel realisiert ist und zwischen einem Bereich (114, 214, 1020) des ersten Stapels, der die vor-freigesetzte Struktur bildet, und dem zweiten Stapel angeordnet ist,
- wenigstens einen Abstandshalter (116, 116a, 116b, 1008), der in dem Hohlraum (112, 1006) angeordnet ist und den Bereich (114, 214, 1020) des ersten Stapels mit dem zweiten Stapel verbindet.

2. Vorrichtung (100, 200, 1000) nach Anspruch 1, wobei der erste und/oder der zweite Stapel ferner wenigstens eine Zwischenschicht (106, 1004) umfassen, die zwischen der ersten Schicht (102, 204, 1014) und der zweiten Schicht (104, 1002) angeordnet ist, wobei der Hohlraum (112) in der Zwischenschicht (106, 1004) und/oder der ersten Schicht (102, 204, 1014) und/oder der zweiten Schicht (104, 1002) realisiert ist.

3. Vorrichtung (100, 200, 1000) nach Anspruch 2, wobei die Zwischenschicht (106, 1004) auf Grundlage eines dielektrischen Materials wie zum Beispiel einem Oxid des ersten und/oder des zweiten Materials hergestellt ist, und/oder einem Halbleiteroxid.

4. Vorrichtung (200) nach einem der vorhergehenden Ansprüche, umfassend mehrere Gruppen von Abstandshaltern (116a, 116b), wobei die Abstandshalter (116a, 116b) jeder Gruppe in einer Ebene parallel zu einer Ebene, welche durch eine Hauptfläche der ersten Schicht (204) oder der zweiten Schicht (104) oder einer Zwischenschicht (106) verläuft, einen Querschnitt aufweisen, der von den Abstandshaltern (116a, 116b) der anderen Gruppen verschieden ist.

5. Vorrichtung (100, 200, 1000) nach einem der vorhergehenden Ansprüche, umfassend eine Mehrzahl von Abstandshaltern (116, 116a, 116b, 1008), die in dem Hohlraum (112, 1006) derart verteilt sind, dass der Abstand zwischen zwei benachbarten Abstandshaltern (116, 116a, 116b, 1008) kleiner ist als ungefähr 50 Mal die Dicke des Bereichs (114, 214, 1020) des ersten Stapels.

6. Vorrichtung (100, 200, 1000) nach einem der vorhergehenden Ansprüche, wobei das erste Material ein Halbleitermaterial ist.

7. Vorrichtung (100, 200, 1000) nach einem der vorhergehenden Ansprüche, wobei das zweite Material ein Halbleitermaterial oder ein dielektrisches Material wie zum Beispiel Glas und/oder Siliziumoxid ist.

8. Vorrichtung (1000) nach einem der vorhergehenden Ansprüche, umfassend in dem ersten und/oder dem zweiten Stapel wenigstens eine Schwächungszone (1012), die die spätere Realisierung einer Verdünnung des ersten und/oder des zweiten Stapels ermöglicht.

9. Verfahren zur Herstellung einer Vorrichtung (100, 200, 1000) mit vor-freigesetzter Struktur, umfassend wenigstens die folgenden Schritte:
- Realisierung wenigstens einer Aushöhlung (112, 1006) in einem ersten Stapel, umfassend wenigstens eine erste Schicht (102, 204, 1014) auf Grundlage wenigstens eines ersten Materials und/oder in einem zweiten Stapel, umfassend wenigstens eine zweite Schicht (104, 1002) auf Grundlage wenigstens eines zweiten Materials, wobei man wenigstens einen Vorsprung (116, 116a, 116b, 1008) in der Aushöhlung (112, 1006) bestehen lässt,
- Kleben des ersten Stapels gegen den zweiten Stapel, wobei die Aushöhlung (112, 1006) einen geschlossenen Hohlraum bildet, der zwischen einem Bereich (114, 214, 1020) des ersten Stapels, welcher die vor-freigesetzte Struktur bildet, und dem zweiten Stapel angeordnet ist, wobei der Vorsprung (116, 116a, 116b, 1008) einen Abstandshalter bildet, der den Bereich (114, 214, 1020) des ersten Stapels mit dem zweiten Stapel verbindet.

10. Verfahren nach Anspruch 9, wobei der erste und/oder der zweite Stapel ferner wenigstens eine Zwischenschicht (106, 1004) umfassen, wobei die Aushöhlung (112, 1006) dann in der Zwischenschicht (106, 1004) und/oder in der ersten Schicht (102, 204, 1014) und/oder in der zweiten Schicht (104, 1002) realisiert wird, und wobei die Zwischenschicht (106, 1004) dann nach dem Schritt des Klebens zwischen der ersten Schicht (102, 204, 1014) und der zweiten Schicht (104, 1002) angeordnet ist.

11. Verfahren nach einem der Ansprüche 9 oder 10, wobei der Schritt der Realisierung der Aushöhlung (112) mehrere Gruppen von Vorsprüngen (116a, 116b) bestehen lässt, wobei die Vorsprünge (116a, 116b) jeder Gruppe in einer Ebene parallel zu einer Ebene, welche durch eine Hauptfläche der ersten Schicht (204) oder der zweiten Schicht (104) oder einer Zwischenschicht (106) verläuft, einen Querschnitt aufweisen, der verschieden ist von den Vorsprüngen (116a, 116b) der anderen Gruppen, wobei die Vorsprünge (116a, 116b) nach dem Schritt des Klebens Abstandshalter (116a, 116b) bilden, die sich zwischen dem Bereich (214) des ersten Stapels und dem zweiten Stapel erstrecken.

12. Verfahren nach einem der Ansprüche 9 bis 11, ferner umfassend einen Schritt des Verdünnens des ersten und/oder des zweiten Stapels.

13. Verfahren nach Anspruch 12, ferner umfassend einen Schritt der Realisierung wenigstens einer Schwächungszone (1012) in dem ersten und/oder dem zweiten Stapel, wobei der Schritt des Verdünnens realisiert wird durch Verwendung wenigstens eines Schritts des Brechens im Bereich der Schwächungszone (1012).

14. Verfahren nach einem der Ansprüche 9 bis 13, wobei die Aushöhlung (112, 1006) und der Vorsprung (116, 116a, 116b, 1008) erhalten werden durch Verwendung wenigstens eines Lithografieschritts und wenigstens eines Gravurschritts in dem ersten und/oder dem zweiten Stapel.

15. Verfahren nach einem der Ansprüche 9 bis 14, wobei der Schritt des Klebens eine molekulare Klebung oder eine anodische Versiegelung ist, die zwischen dem ersten und dem zweiten Stapel realisiert wird.

16. Verfahren zur Herstellung einer Struktur in einer Vorrichtung (100, 200, 1000), umfassend wenigstens die folgenden Schritte:
- Verwenden eines Verfahrens zur Herstellung einer Vorrichtung (100, 200, 1000) mit vor-freigesetzter Struktur nach einem der Ansprüche 9 bis 15,
- Realisierung wenigstens eines Zugangs (118, 1018) zu dem Hohlraum (112, 1006),
- Gravieren wenigstens eines Bereichs des ersten oder des zweiten Stapels zum mechanischen Verbinden des Abstandshalters (116, 116a, 116b, 1008) mit dem ersten oder dem zweiten Stapel und/oder des Ganzen oder eines Teils des Abstandshalters (116, 116a, 116b, 1008) unter Freisetzen des Bereichs (114, 214, 1020) des ersten Stapels von dem zweiten Stapel.

17. Verfahren zur Freisetzung einer Struktur einer Vorrichtung (100, 200, 1000) nach einem der Ansprüche 1 bis 8, umfassend wenigstens die folgenden Schritte:
- Realisieren wenigstens eines Zugangs (118, 1018) zu dem Hohlraum (112, 1006),
- Gravieren wenigstens eines Bereichs des ersten oder des zweiten Stapels zum mechanischen Verbinden des Abstandshalters (116, 116a, 116b, 1008) mit dem ersten oder dem zweiten Stapel und/oder des Ganzen oder eines Teils des Abstandshalters (116, 116a, 116b, 1008) unter Freisetzen des Bereichs (114, 214, 1020) des ersten Stapels von dem zweiten Stapel.

18. Verfahren nach einem der Ansprüche 16 oder 17, wobei die Realisierung des Zugangs (118) zu dem Hohlraum (112) durch wenigstens einen Lithografieschritt und wenigstens einen Gravurschritt erzielt wird.

## Claims

1. Pre-released structure device (100, 200, 1000) comprising:
- at least one first stacking, comprising at least one first layer (102, 204, 1014) based on at least one first material, arranged against a second stacking comprising at least one second layer (104, 1002) based on at least one second material,
- at least one closed cavity (112, 1006), formed in the first and/or the second stacking, and arranged between a portion (114, 214, 1020) of the first stacking forming the pre-released structure and the second stacking,
- at least one spacer (116, 116a, 116b, 1008) arranged in the cavity (112, 1006) and linking the portion (114, 214, 1020) of the first stacking to the second stacking.

2. Device (100, 200, 1000) according to claim 1, in which the first and/or the second stacking further comprise at least one intermediate layer (106, 1004) arranged between the first layer (102, 204, 1014) and the second layer (104, 1002), wherein the cavity (112) is formed in the intermediate layer (106, 1004) and/or the first layer (102, 204, 1014) and/or the second layer (104, 1002).

3. Device (100, 200, 1000) according to claim 2, in which the intermediate layer (106, 1004) is based on a dielectric material such as an oxide of the first and/or the second material, and/or a semi-conductor oxide.

4. Device (200) according to one of the previous claims, comprising several groups of spacers (116a, 116b), the spacers (116a, 116b) of each group comprising, in a plane parallel to a plane passing through a principal face of the first layer (204) or the second layer (104) or an intermediate layer (106), a section different to the spacers (116a, 116b) of the other groups.

5. Device (100, 200, 1000) according to one of the previous claims, comprising a plurality of spacers (116, 116a, 116b, 1008) spread out in the cavity (112, 1006) such that the distance between two neighbouring spacers (116, 116a, 116b, 1008) is less than around fifty times the thickness of the portion (114, 214, 1020) of the first stacking.

6. Device (100, 200, 1000) according to one of the previous claims, in which the first material is a semi-conductor material.

7. Device (100, 200, 1000) according to one of the previous claims, in which the second material is a semi-conductor material, or a dielectric material such as glass and/or silica.

8. Device (1000) according to one of the previous claims, comprising in the first and/or the second stacking, at least one weakened zone (1012) enabling the subsequent carrying out of a thinning of the first and/or the second stacking.

9. Method for producing a pre-released structure device (100, 200, 1000), comprising at least the steps of:
- forming at least one hollow (112, 1006) in a first stacking, comprising at least one first layer (102, 204, 1014) based on at least one first material, and/or in a second stacking, comprising at least one second layer (104, 1002) based on at least one second material while leaving at least one protuberance (116, 116a, 116b, 1008) in the hollow (112, 1006) remaining,
- bonding of the first stacking against the second stacking, the hollow (112, 1006) forming a closed cavity arranged between a portion (114, 214, 1020) of the first stacking forming the pre-released structure and the second stacking, the protuberance (116, 116a, 116b, 1008) forming a spacer linking the portion (114, 214, 1020) of the first stacking to the second stacking.

10. Method according to claim 9, in which the first and/or the second stacking further comprise at least one intermediate layer (106, 1004), the hollow (112, 1006) then being formed in the intermediate layer (106, 1004) and/or in the first layer (102, 204, 1014) and/or in the second layer (104, 1002), and the intermediate layer (106, 1004) then being arranged, after the bonding step, between the first layer (102, 204, 1014) and the second layer (104, 1002).

11. Method according to one of claims 9 or 10, in which the step of forming the hollow (112) leaves several groups of protuberances (116a, 116b) remaining, the protuberances (116a, 116b) of each group comprising, in a plane parallel to a plane passing through a principal face of the first layer (204) or the second layer (104) or an intermediate layer (106), a section different to the protuberances (116a, 116b) of the other groups, the protuberances (116a, 116b) forming, after the bonding step, spacers (116a, 116b) extending between the portion (214) of the first stacking and the second stacking.

12. Method according to one of claims 9 to 11, further comprising a step of thinning of the first and/or the second stacking.

13. Method according to claim 12, further comprising a step of forming at least one weakened zone (1012) in the first and/or the second stacking, wherein the step of thinning is carried out by the implementation of at least one fracture step at the level of the weakened zone (1012).

14. Method according to one of claims 9 to 13, in which the hollow (112, 1006) and the protuberance (116, 116a, 116b, 1008) are obtained by the implementation of at least one lithography step and at least one etching step in the first and/or the second stacking.

15. Method according to one of claims 9 to 14, in which the bonding step is a molecular bonding or an anodic sealing carried out between the first and the second stacking.

16. Method for producing a structure in a device (100, 200, 1000), comprising at least the steps of:
- implementing a method for producing a pre-released structure device (100, 200, 1000) according to one of claims 9 to 15;
- forming at least one access (118, 1018) to the cavity (112, 1006);
- etching at least one portion of the first or the second stacking mechanically linking the spacer (116, 116a, 116b, 1008) to the first or to the second stacking and/or all or part of the spacer (116, 116a, 116b, 1008), liberating the portion (114, 214, 1020) of the first stacking, from the second stacking.

17. Method of releasing a structure of a device (100, 200, 1000) according to one of claims 1 to 8, comprising at least the steps of:
- forming at least one access (118, 1018) to the cavity (112, 1006),
- etching at least one portion of the first or the second stacking mechanically linking the spacer (116, 116a, 116b, 1008) to the first or to the second stacking and/or all or part of the spacer (116, 116a, 116b, 1008), liberating the portion (114, 214, 1020) of the first stacking from the second stacking.

18. Method according to one of claims 16 or 17, in which the formation of the access (118) to the cavity (112) is obtained by at least one lithography step and at least one etching step.
